# EUROPEAN PATENT APPLICATION

(11) **EP 2 375 452 A1**
(43) Date of publication of application: **12.10.2011**
(21) Application number: 10159174.1
(22) Date of filing: 06.04.2010
(51) Int. Cl.: H01L 31/0216, G02B 1/11

(54) **Nanoparticle antireflection layer**

(71) Applicant: FOM Institute for Atomic and Moleculair Physics, 1098 SJ Amsterdam (NL)
(72) Inventor: De Waele, Rene, 3038 AA, Rotterdam (NL); Hebbink, Maarten, 7021 KC, Zelhem (NL); Polman, Albert, 1019 AX, Amsterdam (NL)
(74) Representative: Visscher, Erik Henk

(57) **Abstract**

A thin-film broadband antireflection layer for use with an optical element or an optoelectronic device is described, wherein the thin-film broadband antireflection layer comprises: at least a thin-film dielectric layer; and, at least one array of nanoparticles disposed onto or in said thin-film dielectric layer, wherein the dielectric constant of said nanoparticles is substantially distinct from distinct from the dielectric constant of said dielectric layer.

## Description

### Field of the invention

The invention relates to a nanoparticle antireflection layer and, in particular, though not necessarily, to a nanoparticle thin-film broadband antireflection layer, to optical elements and optoelectronic devices comprising such antireflection layer and to the use of such nanoparticles in an antireflection layer.

### Background of the invention

Antireflection (AR) coatings (layers) are well known optical coatings used in optical devices or elements in order to reduce reflection of light. The use of such AR coatings cover a wide range of important optical applications including AR coatings for optical elements, e.g. lenses, and optoelectronic devices, e.g. solar cells, light emitting diodes, lasers, and displays. Conventional AR coatings are based on interference effects in one or more dielectric layers of a specific thickness and refractive index. A single layer AR coating is inherently unable to reduce reflection over a broad range of wavelengths. This is particularly important in solar cells, that convert the broad spectral range emitted by the sun to electricity. Moreover such conventional AR coatings suffer from undesired angle dependences.

In order to solve this problem typically multilayer graded-index AR coatings are used. For example, Chhajed et al. describe in their article "Nanostructured multilayer graded-index antireflection coating for Si solar cells with broadband and omnidirectional characteristics" (Applied Physics Letters 93, 251108 (2008)) the use of multilayer graded-index AR coatings comprising a low refractive index nanostructured porous silicon dioxide top layer. Other ways of achieving graded index antireflection coatings are described in US7,170,666, which describes a method for etching nanostructures into a thin film oxide layer thereby realizing a graded index oxide surface. Such broadband graded index multilayer antireflection coatings however require tight control of process parameters, e.g. the layer thicknesses and layer compositions, and are thus not suitable for implementation in mass produced optical devices and elements.

Hence, there is a need in the art for providing improved AR coatings, which provide effective broadband antireflection properties over a wide range of incident angles. Moreover, there is a need in the art for broadband AC coatings which are simple to fabricate.

### Summary of the invention

It is an object of the invention to reduce or eliminate at least one of the drawbacks in the prior art. In one aspect, the invention may relate to a thin-film broadband antireflection layer for use with an optical element or an optoelectronic device, wherein said antireflection layer comprises: at least one thin-film dielectric layer; and, at least one array of nanoparticles disposed onto or in said thin-film dielectric layer, wherein the of dielectric constants of said nano-particles is substantially different than that of said dielectric layer. Such nanoparticle antireflection layer provides improved antireflective properties over a broad range of wavelength.

In one embodiment said thin-film dielectric layer may comprise silicon dioxide, silicon nitride, (Tetra-ethylorthosilicate) TEOS, a organic resin, a polymer, a semiconducting layer and/or combinations thereof.

In one embodiment said thin-film dielectric may have a thickness approximately between 10 and 300 nm, preferably between 50 and 100 nm.

In yet another embodiment the average dimensions of said nanoparticles may be selected between approximately 50 and 300 nm and wherein the average distance between said particles is selected between 200 and 700 nm.

In a further embodiment at least part of said nanoparticles may be metal nanoparticles, In yet a further embodiment said metal may be selected from the group of Au, Ag, Cu, Al and/or alloys thereof.

In one variant at least part of said nanoparticles may be semiconducting nanoparticles. In another variant said semiconducting material may be selected from the group IV semiconductors, the III-V or II-VI semiconducting compounds and/or combinations thereof.

In a further variant, at least part of said nanoparticles may be metaloxide nanoparticles. In yet a further variant said metaloxide may relate to high-refractive index oxides selected from the group of A12O3, Ta2O5, Ti3O5, TiO2, ZiO2, Nb2O5, CeO2 and Si3N4.

In one embodiment at least part of said nanoparticles has a substantially spheroidal shape; in another embodiement at least part of said nanoparticles are substantially cylindrically shaped.

In a further aspect, the invention may relate to a multilayer structure comprising at least one antireflection layer according to any of the embodiments and/or variants as described above.

In other aspects the invention may relate to an optical element, preferably an optical lens or a display screen, comprising an antireflection layer according to any of the embodiments and/or variants as described above or to an optoelectronic device, preferably a light-receiving or a light-emitting device, comprising an antireflection layer according to any of the embodiments and/or variants as described above.

In one embodiment said antireflection layer is deposited onto a thin-film light absorbing or light-emitting layer associated with an optoelectronic device.

In yet a further aspect, the invention relates to the use of an array of dielectric nanoparticles, preferably metallic nanoparticles, as at least part of an antireflective coating. In one embodiment, the average dimensions of said used nanoparticles may be selected between approximately 100 and 300 nm and wherein the average distance between said particles is selected between 200 and 700 nm. In another embodiment, at least part of said used nanoparticles may be metal nanoparticles, preferably said metal being selected from the group of Au, Ag, Cu, Al and/or alloys thereof; and/or, wherein at least part of said used nanoparticles may be semiconducting nanoparticles, preferably said semiconducting material being selected from the group IV semiconductors, the III-V or II-VI semiconducting compounds and/or combinations thereof; and/or wherein at least part of said used nanoparticles may be metaloxide nanoparticles, preferably high-refractive index oxides selected from the group of Ta205, Ti305, TiO2, ZiO2, Nb2O5, CeO2 and Si3N4.

The invention will be further illustrated with reference to the attached drawings, which schematically show embodiments according to the invention. It will be understood that the invention is not in any way restricted to these specific embodiments.

### Brief description of the drawings

**Fig. 1** illustrates the transmittance of light into a silicon substrate covered with a nanoparticle AR coating according to one embodiment of the invention.
**Fig. 2** depicts the enhancement factor as a function of the Ag nanoparticle height for a nanoparticle AR coating according to one embodiment of the invention.
**Fig. 3** depicts the enhancement factor as a function of (a) the particle height and (b) thin-film dielectric layer for various other embodiments of the invention.
**Fig. 4** depicts the enhancement factor as a function of (a) the particle width and (b) height and (c) pitch for various other embodiments of the invention.
**Fig. 5** depicts the enhancement factor as a function of the shape of the nanoparticles.
**Fig. 6** depicts the transmittance of light into a silicon substrate covered with a nanoparticle AR coating according to yet another embodiment of the invention.

### Detailed description

In contrast with conventional AR coatings, which are designed to match the refractive index of air with the refractive index of the optical element or optoelectronic device using a stack of dielectrics having a low refractive top dielectric layer and a relatively high refractive index bottom dielectric layer, the present invention uses an array of nanoparticles provided onto the surface or embedded into the surface of a thin-film dielectric.

Further, the use of metals in antireflection coatings is uncommon, as metal films are know as good reflectors. In the present invention the nanostructure of the metal particles, and their assembly in regular arrays or random geometries, leads to efficient anti-reflective properties.

In particular, the present invention uses the scattering properties of light, which depend on the optical constants of the nanoparticles, the optical constants of the surrounding dielectric and the optical constants of the substrate. Light is preferentially scattered by the nanoparticles into the high-refractive index substrate material, thereby rendering the metal nanoparticle arrays effective anti-reflective coatings. A further advantage of this invention for applications for exemple in solar cells is taht the scattered light acquires an angular spread in the substrate, which can lead to more effectively absorption of light in the solar cell. This is a particularly important advantage for thin-film solar cells.

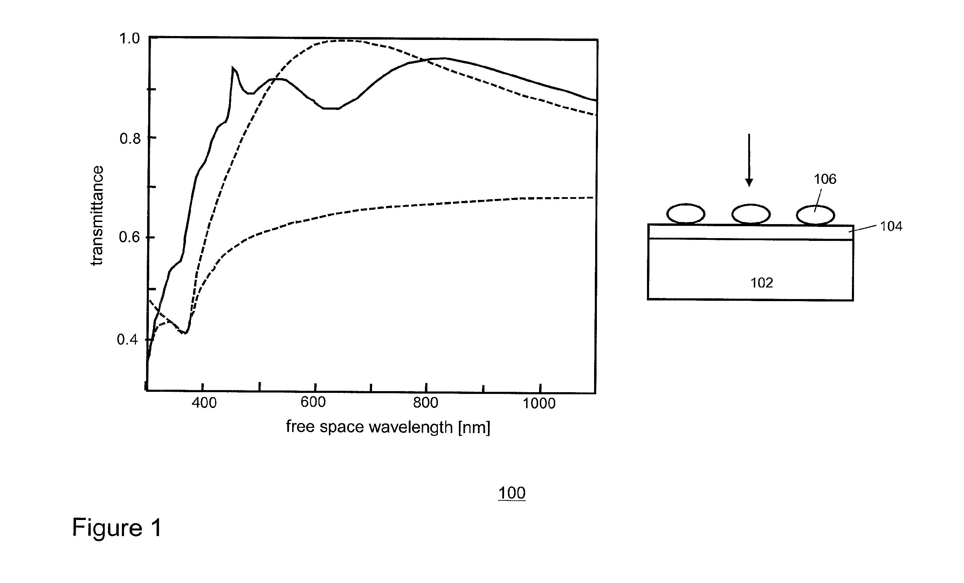

**Fig. 1** illustrates the transmittance of light through a nano-particle AR coating according to one embodiment of the invention. In particular, the example used in **Fig. 1** relates to a crystalline Silicon (c-Si) substrate **102** comprising a 50 nm thin-film Si3N4 dielectric layer **104** on which an array of Ag nano-particles **106** is deposited. The particle dimensions are approximately 200 nm wide by 175 nm high and array pitch in this example is approximately 450 nm. The transmittance light into the substrate of the nanoparticle AR coating is compared with the transmittance of a bare Silicon substrate and a Silicon substrate (n ∼ 3,92) covered with a conventional 80 nm thick Si3N4 AR coating (n ∼ 2.05). The spectral range in **Fig. 1** corresponds to the wavelength range at which sunlight is typically absorbed in a solar cell. While a bare c-Si substrate has a transmittance ranging from 0.4 - 0.65, the nanoparticle coated c-Si substrate shows much higher transmittance.

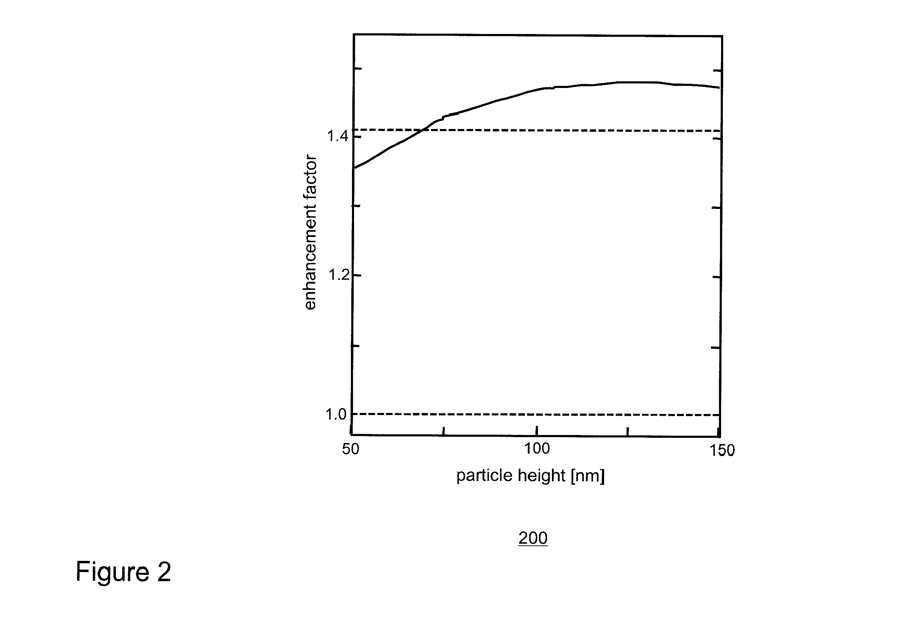

Although the effect the effect at 650 nm is not so high as for a standard AR coating, the total enhancement is larger due to the broadband effect provided by the nanoparticles. This is illustrated in more detail in **Fig. 2****,** which depicts the total enhancement (i.e. a spectrum such as in **Fig. 1** integrated over the whole AM1.5 solar spectrum) of light transmitted into the Silicon substrate due to the presence of a nanoparticle AR coating as a function of the particle height. In this example, silver nanoparticles are placed on a 50 nm thick Si3N4 layer and the silver particles have an ellipsoidal shape. Data for a bare Silicon substrate and a Silicon substrate covered with a 80 nm thick Si3N4 AR coating are provided as a reference.

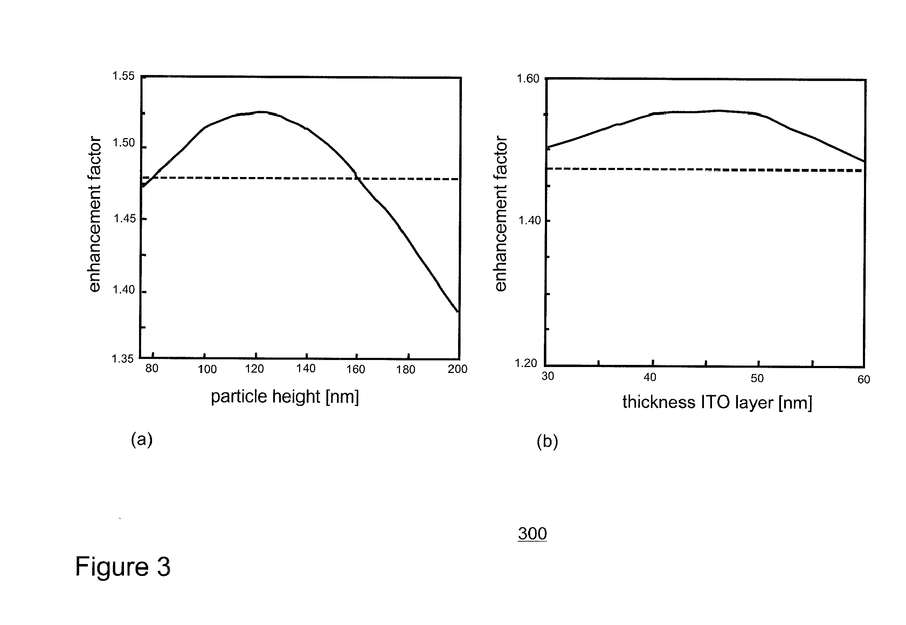

In **Fig. 2** it can be seen that the nanoparticle thin-film AR coating allows improved AR properties, in particular a more than 8% improvement, when compared with the conventional Si3N4 AR coating. Maximum improvement is achieved for nanoparticles having a height of at least 75 nm or more. The enhancement factor for a particle thin-film AR coating may be dependent on various parameters as depicted in **Fig. 3(a)** and **(b).**

**Fig 3(a)** depicts an embodiment wherein the enhancement factor is measured for a nanoparticle AR coating on top of a-Si as a function of particle height. In this example, the nanoparticle AR coating comprises cylindrical Ag particles of approximately 200 nm width and an array pitch of approximately 450 nm placed on a 50 nm thick Si3N4 thin-film dielectric. **Fig. 3(a)** indicates that for these parameters, in particular for particles of 200 nm width and having a height in a range between approximately 100 and 150 nm the enhancement factor for cylindrical particles is similar to spheroidal particles as described with reference to **Fig. 2**. This may be explained by to the fact that for these particular parameters the light coupling is particularly enhanced at the part of the spectrum where a-Si absorbs light better than c-Si.

**Fig. 3(b)** depicts an embodiment wherein the enhancement factor is measured for a nanoparticle AR coating as a function of the thin-film dielectric layer, in this case a thin-film Indium Tin Oxide (ITO) layer, i.e. a transparent conducting layer (TCO), on top of an a-Si substrate. In this example Ag spheroids of 200 nm width and 125 nm height and an array pitch of approximately 450 nm were used. Such nanoparticle AR coating may be advantageously used in a photovoltaic cell based on a-Si. From this figure it follows that a substantial enhancement factor is present over a wide range of ITO thicknesses, in this case between approximately 20 and 60 nm, preferably between approximately 40 and 50 nm.

Hence, the inventors have discovered that combining a thin-film dielectric layer with nanoparticles comprising a material having a dielectric constant distinctly different than that of their surrounding forms a very simple and effective broadband AR coating. The present invention is based on the insight that such nanoparticles may be used as strong light scatters. For example, for metallic nanoparticles, e.g. Ag or Au nanoparticles of sufficiently large size, there is almost no absorption in the particles and the scattering cross section may well exceed the particle's geometrical cross section. Such particles may thus be used as effective light scatters requiring a relatively small surface coverage. Depending on particle size, such optimized coverage may be in the order of approximately 10-20% of the surface area.

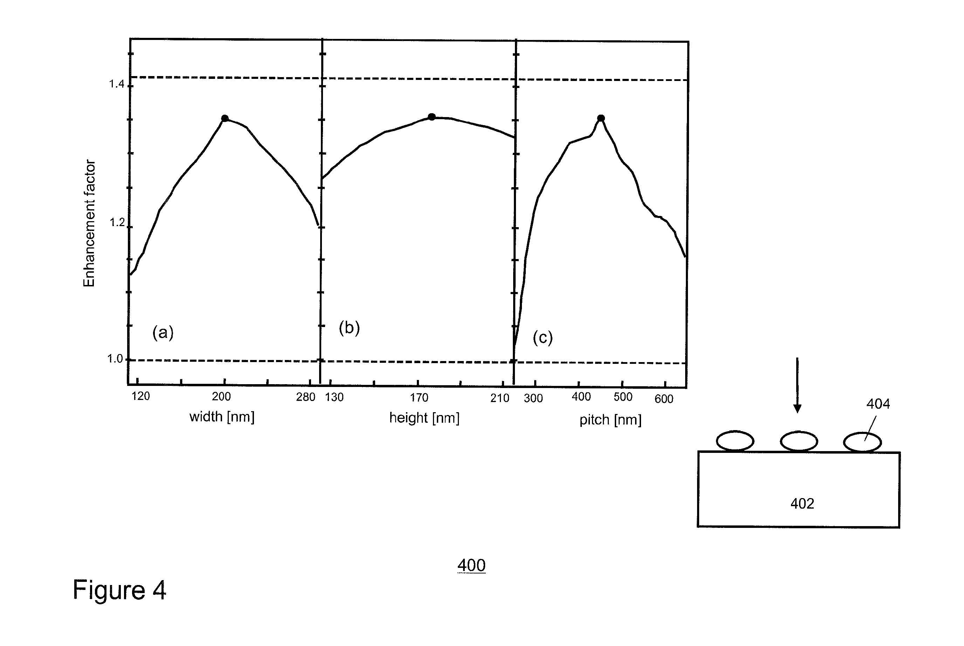

Due to the presence of an array of nanoparticles on top of a substrate having a higher dielectric index than air, light scattered by the nanoparticles will preferentially scatter into the substrate. **Fig. 4** illustrates the enhancement of light transmitted into a crystalline substrate **402** due to presence of metallic nanoparticles **404** directly placed on the surface of a silicon substrate for various nanoparticle array configurations. The (maximum) enhancement factor associated with a conventional 80 nm thick Si3N4 AR coating and the enhancement factor for a bare c-Si substrate are added as a reference. In these data, the enhancement is calculated by performing a weighted average of the enhancement over the solar spectrum, limited to wavelengths below the band gap of c-Si.

From **Fig. 4** it may be derived that nanoparticle arrays comprising nanoparticles having a particle width within the range between 160 and 280 nm, a particle height between 130 and 220 nm and a array pitch within the range between 300 and 600 nm effectively enhances transmission of light into the substrate when compared to the bare c-Si reference. Maximum enhancement of approximately 1,35 is achieved of particles of approximately 200 by 175 nm arranged in an array having a pitch of approximately 450 nm.

Further, from **Fig. 4** it may be generally understood that if the particles (i.e. the particle widths or heights) are too small, the fraction of light interacting with the particle that scatters into the substrate is high, but the scattering efficiency is very low and the absorption in the particles may be relatively high. If, on the contrary, particles are too large, the scattering efficiency is large, but only a relatively small part of the scattered light goes into the substrate. For the particle height, similarreasons may apply as with the particle width. Further, if the pitch is low, the surface coverage will become high and the particle layer effectively becomes a (semi)continuous layer which for example in case of metal nanoparticles may become a metallic reflecting layer or for example in case of dielectric nanoparticles may become a dielectric layer producing classical interference effects.

One of the advantageous of using metal nanoparticles in the formation of a nanoparticle AR coating on e.g. a solar cell, is that metals (e.g. Ag or Al) are used for the formation of the electrical top contact of the solar cell. In this way deposition of electrical contacts and a nanoparticle AR coating may be realized in a single processing step using the same metal. In some embodiments, it is found that the transmittance of light is improved by placing the nanoparticles on a thin dielectric spacer layer on the substrate. Such spacer layers may e.g. be the thin passivation layer that is already present in a standard semiconductor manufacturing process.

As will be described in more detail hereunder, the nanoparticle AR coating according to the invention is not limited to the materials as described with reference to **Fig**. **1-4** and may be applied in various combinations without departing from the invention. These variants and the advantages associated with the invention, will be discussed hereunder in more detail.

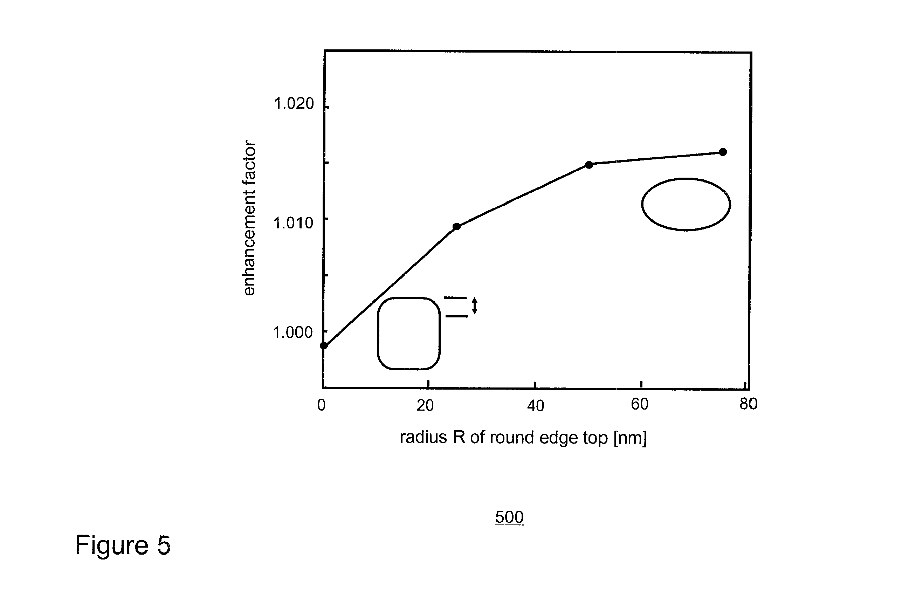

**Fig. 5** illustrates the influence of shape of the nanoparticles used in the nanoparticle AR coating. In particular, this figure illustrates the change in the enhancement factor (calculated for a single particle over a certain area of c-Si) when the particle shape is changed from a cylinder to a spheroid, while keeping the particle width and volume approximately constant. From this figure it may be derived that in some geometries spheroidal particles may provide better AR properties than cylindrical particles.

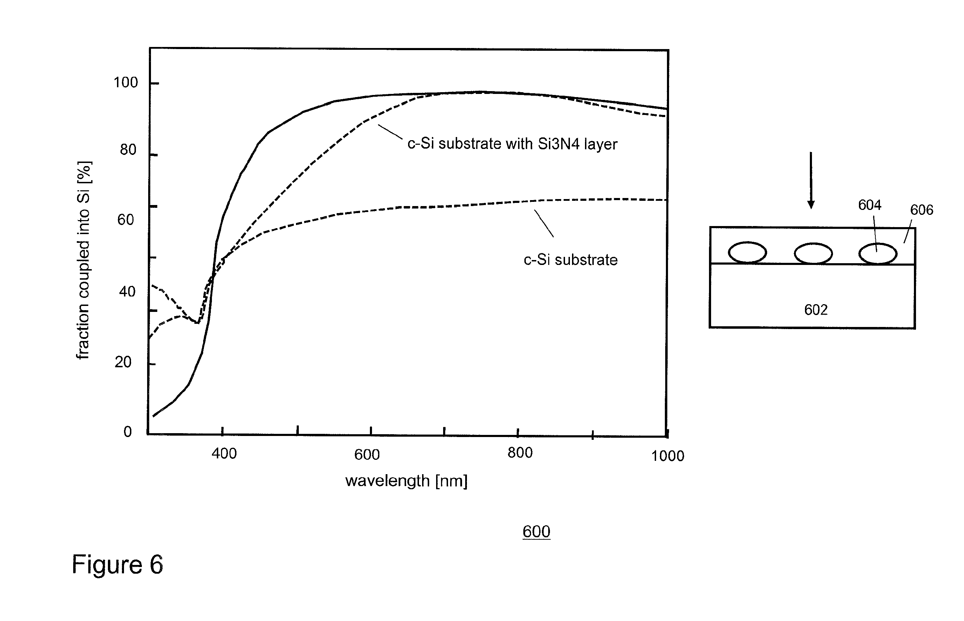

**Fig. 6** depicts yet another embodiment wherein semiconducting nanoparticles are used in the nanoparticle AR coating. In this embodiment, an array of spheroidal Si nanoparticles is disposed on a c-Si substrate. The array of nanoparticles of approximately 160 nm width and 50 nm height has an array pitch of approximately 200 nm. Over the substrate and the array a 120 nm a thin-film dielectric (n=1.5) is deposited, so that the Si nanoparticles are embedded in the thin-film dielectric.

In **Fig. 6** can be seen that a Si nanoparticle AR coating provides the same enhancement as a conventional Si3N4 coating of 80 nm for the red part of the solar spectrum, but enhances coupling of light into the substrate in the blue part above 370 nm. Hence, the results in **Fig. 6** indicate that also non-metallic nanoparticles with a high dielectric constant such as semiconducting nanoparticles, e.g. Si, or insulating nanoparticles, e.g. nanoparticles from high refractive metal oxides such as A12O3, Ta2O5, Ti3O5, TiO2, ZiO2, Nb2O5, CeO2 and Si3N4 may be used as strong light scatters for use in a nanoparticle AR coating according to the invention. In this embodiment, the Si nanoparticles are embedded in the thin-film dielectric layer thereby providing the advantage that the Si nanoparticles are prevented from being oxidized. The thin-film dielectric layer thus additionally functions as a passivation layer for the nanoparticles. Moreover, such thin-film dielectric layer comprising embedded nanoparticles provides mechanical robustness.

In a further embodiments, metal nanoparticles as described with reference to **Fig. 1-5** may be embedded in the thin-film dielectric layer. For example Ag nanoparticles of 200 nm width and 125 nm height and an array pitch of 450 nm may be embedded in a 225 nm thick Si3N4 dielectric. That way, the Ag nanoparticles are prevented from being oxidized.

The materials and AR coating structures used in the embodiments described with reference to **Fig. 1-6** are only for illustration and in no way limiting the invention. For example, typical substrates, which may be coated with a nanoparticle AR coating according to the invention may generally relate to any kind of transparent glass-type substrates for use in optical elements and display device. Other foreseen substrates include semiconducting substrates used in optoelectronic devices such as photovoltaic devices, including amorphous or a (poly)crystalline semiconductor substrates, wherein the semiconductor may be selected from the group consisting of silicon, GaAs and related III-V compounds, CdTe, Cu(In,Ga)(Se,S) CdSe, PbS, PbSe, engineered materials e.g. a quantum dot superlattice or any other semiconductor materials. Further, organic-type optical elements and optoelectrionic devices are also foreseen.

Moreover, it is submitted that the nanoparticle AR coating may be part of a multilayered structure comprising e.g. one or more passivation layers deposited on top of the nanoparticles. Such passivation layer may for example comprise a UV curable resin well known in the art. Further, an array of nanoparticles may both include twodimensional arrangements with a predetermined pitch and random arrangements of nanoparticles. In such randomized arrangements instead of the array pitch the effective surface coverage (% per unit of area) may be used as one of the parameters defining the nanoparticle AR coating.

The nanoparticle AR coating may be fabricated using various known lithography techniques such as UV, X-ray, e-beam lithography and other related techniques in combination with known thin-film deposition methods such as for example sputtering, thermal evaporation, chemical vapour deposition or sol-gel techniques.

Further, an adapted screen-print or inkjet printing technique may be used which allowing direct printing of nanosized metal structures (see e.g. Zhao et al., "Self-aligned inkjet printing of highly conducting gold electrodes with submicron resolution", Journal of Applied Physics 101, 064513, 2007).

One particular useful technique for large area application is the imprint lithography technique. One embodiment of this technique is for example described in US patent application US2008/0011934, which is hereby incorporated by reference into this application. Using this method an imprint template corresponding to the pattern of a predetermined nanoparticle array with typical dimensions as described in relation with **Fig. 1-6** is made. The structure of the imprint template is transferred to a curable resin layer which is disposed over the semiconductor layer of the photovoltaic cell. After curing the resin the patterned resist layer is etched in order to expose the surface of the semiconductor layer. Deposition of a metal layer over the imprinted resist pattern, followed by a lift-off finalizes the realization of the contact structure.

It is to be understood that any feature described in relation to any one embodiment may be used alone, or in combination with other features described, and may also be used in combination with one or more features of any other of the embodiments, or any combination of any other of the embodiments. Moreover, the invention is not limited to the embodiments described above, which may be varied within the scope of the accompanying claims.

## Claims

1. A thin-film broadband antireflection layer for use with an optical element or an optoelectronic device, comprising:
at least a thin-film dielectric layer;
at least one array of nanoparticles disposed onto or in said thin-film dielectric layer, wherein the dielectric constant of said nanoparticles is substantially distinct from distinct from the dielectric constant of said dielectric layer.

2. Antireflection layer according to claim 1, wherein said thin-film dielectric layer comprises silicon dioxide, silicon nitride, (Tetra-ethylorthosilicate) TEOS, an organic resin, polymer, a semiconductor and/or combinations thereof.

3. Antireflection layer according to claims 1 or 2, wherein said thin-film dielectric has a thickness approximately between 10 and 300 nm, preferably between 50 and 100 nm.

4. Antireflection layer according to any of claims 1-3, wherein the average dimensions of said nanoparticles are selected between approximately 100 and 300 nm and wherein the average distance between said particles is selected between 200 and 700 nm.

5. Antireflection layer according to any of claims 1-4, wherein at least part of said nanoparticles are metal nanoparticles, preferably said metal being selected from the group of Au, Ag, Cu, Al and/or alloys thereof.

6. Antireflection layer according to any of claims 1-4, wherein at least part of said nanoparticles are semiconducting nanoparticles, preferably said semiconducting material being selected from the group IV semiconductors, the III-V or II-VI semiconducting compounds and/or combinations thereof.

7. Antireflection layer according to any of claims 1-4, wherein at least part of said nanoparticles are metal oxide nanoparticles, preferably high-refractive index oxides selected from the group of Al2O3, Ta2O5, Ti3O5, TiO2, ZiO2, Nb205, Ce02 and Si3N4.

8. Antireflection layer according to any of claims 1-7, wherein at least part of said nanoparticles has a substantially spheroidal shape.

9. Multilayer structure, comprising at least one antireflection layer according to any of claims 1-7.

10. Optical element, preferably an optical lens or a display screen, comprising an antireflection layer according to any of claims 1-8.

11. Optoelectronic device, preferably a light-receiving or a light-emitting device, comprising an antireflection layer according to any of claims 1-8.

12. Optoelectronic device, wherein said antireflection layer is deposited onto a thin-film light absorbing or light-emitting layer.

13. Use of an array of dielectric nanoparticles, preferably metallic nanoparticles, as at least part of an antireflective coating.

14. Use according to claim 12, wherein the average dimensions of said nanoparticles are selected between approximately 100 and 300 nm and wherein the average distance between said particles is selected between 200 and 700 nm.

15. Use according to claims 12 or 13, wherein at least part of said nanoparticles are metal nanoparticles, preferably said metal being selected from the group of Au, Ag, Cu, Al and/or alloys thereof; and/or, wherein at least part of said nano particles are semiconducting nanoparticles, preferably said semiconducting material being selected from the group IV semiconductors, the III-V or II-VI semiconducting compounds and/or combinations thereof; and/or wherein at least part of said nanoparticles are metaloxide nanoparticles, preferably high-refractive index oxides selected from the group of Ta2O5, Ti3O5, TiO2, ZiO2, Nb205, Ce02 and Si3N4.
